(19) Europäisches Patentamt
European Patent Office
Office européen des brevets

(11) **EP 2 395 653 B1**

(12) **EUROPÄISCHE PATENTSCHRIFT**

(45) Veröffentlichungstag und Bekanntmachung des Hinweises auf die Patenterteilung:
**22.04.2020 Patentblatt 2020/17**

(21) Anmeldenummer: **11001562.5**

(22) Anmeldetag: **25.02.2011**

(51) Int Cl.:
*H02P 25/034* (2016.01)   *G03F 7/20* (2006.01)
*H02P 25/04* (2006.01)   *H02P 5/685* (2006.01)

(54) **Verfahren zum Ansteuern dreier einphasiger Motoren und Bewegen einer Plattform in eine Normalenrichtung, sowie hierzu geeignete Plattform**

Method for controlling three single-phase motors and moving a platform in a normal direction and appropriate platform

Procédé de commande de trois moteurs monophasiques et de déplacement d'une plateforme dans une direction normale et plateforme appropriée

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.06.2010 DE 102010023123**

(43) Veröffentlichungstag der Anmeldung:
**14.12.2011 Patentblatt 2011/50**

(73) Patentinhaber: **ETEL S.A.**
**2112 Môtiers (CH)**

(72) Erfinder:
• **Mathia, Michel**
**2108 Couvet (CH)**
• **Froidevaux, Claude**
**2300 La Chaux-de-Fonds (CH)**
• **Sudan, Jacques-André**
**2016 Cortaillod (CH)**

(74) Vertreter: **Pleyer, Hans Anno**
**Dr. Johannes Heidenhain GmbH**
**Patentabteilung**
**Postfach 12 60**
**83292 Traunreut (DE)**

(56) Entgegenhaltungen:
DE-A1- 19 956 709   DE-A1-102008 042 201
FR-A1- 2 924 874   US-A1- 2004 051 402

EP 2 395 653 B1

**Beschreibung**

Die vorliegende Erfindung betrifft ein Verfahren zum Ansteuern dreier einphasiger Motoren und Bewegen einer Plattform in eine Normalenrichtung, sowie eine hierzu geeignete Plattform. Solche Plattformen dienen beispielsweise der Aufnahme von zu bearbeitenden Gegenständen wie eines Wafers. Dabei ist oft eine sehr genaue Positionierung der Plattform notwendig. Die vorliegende Erfindung beschäftigt sich mit der Feinpositionierung einer solchen Plattform in einer Normalenrichtung.

In der US 6841956 B2 ist in der Beschreibung zur Figur 9 erwähnt, dass eine horizontal in X - und Y - Richtung beweglich gelagerte Plattform zur Aufnahme eines Wafers zusätzlich mittels dreier einphasiger Motoren (Voice-Coil-Motoren) in einer Z - Richtung verstellbar ist, um eine genaue Positionierung des Wafers in Z - Richtung zu ermöglichen. Die Z-Richtung steht dabei senkrecht auf der Plattform und sei hier auch als Normalenrichtung bezeichnet. Die drei Voice-Coil-Motoren wirken dabei alle in die gleiche Richtung, können die Plattform also an ihrem jeweiligen Angriffspunkt entlang der Z-Richtung verstellen.

In der DE 19956709 A1 ist die Ansteuerung von vier einphasigen Motoren mittels eines dreiphasigen Umrichters offenbart. In der FR 2924874 A1 werden zwei einphasige Motoren mit einem dreiphasigen Umrichter angesteuert. In der DE 102008042201 A1 ist eine Spanungsregelung eines Umrichters offenbart, mit der Sollströme in einen Motor eingeprägt werden.

Aus der EP 1691476 B1 ist es bekannt, einen eigentlich zur Ansteuerung eines dreiphasigen Motors gedachten dreiphasigen Umrichter zur Ansteuerung eines zweiphasigen Motors zu verwenden. Dies hat unter anderem den Vorteil, dass solche dreiphasigen Umrichter als häufig verwendete Standardbaugruppe besonders kostengünstig verfügbar sind.

Die vorliegende Anmeldung beschäftigt sich einerseits mit einem Verfahren zur Ansteuerung von drei einphasigen Motoren zum Positionieren einer Plattform, und andererseits mit einer solchen Plattform.

Aufgabe der Erfindung ist es, ein Verfahren und eine Vorrichtung anzugeben, so dass drei in eine gemeinsame Richtung wirkende einphasige Motoren zum Bewegen einer Plattform in eine Richtung möglichst einfach und mit geringem Aufwand angesteuert werden können, wobei dennoch gewisse Freiheitsgrade bei der Ansteuerung vorhanden sind, die es erlauben, die Ansteuerung optimal auf die jeweiligen Anforderungen zu justieren.

Die Aufgabe wird gelöst durch ein Verfahren mit den Merkmalen des Anspruchs 1, sowie durch eine Plattform mit den Merkmalen des unabhängigen Vorrichtungsanspruchs.

Es wird eine Verfahren beschrieben zum Ansteuern dreier einphasiger Motoren und Bewegen einer Plattform in eine Normalenrichtung, wobei die Motoren von einem dreiphasigen Umrichter angesteuert werden, so dass ein erster Motor zwischen einer ersten Phase und einer zweiten Phase des Umrichters betrieben wird, und eine Reihen- oder Parallelschaltung aus einem zweiten und dritten Motor zwischen einer zweiten Phase und einer dritten Phase des Umrichters betrieben wird. Eine Plattform, die geeignet ist, dieses Verfahren auszuführen, wird ebenso offenbart.

Wie unten noch näher ausgeführt wird, lässt sich mit diesem Verfahren bzw. für eine solche Plattform eine relativ einfache Regelstruktur aufbauen, die einerseits die für eine stabile Regelung notwendige Parametrierbarkeit aufweist, aber andererseits durch die Verwendung eines herkömmlichen dreiphasigen Umrichters kostengünstig zu realisieren ist.

Weitere Vorteile sowie Einzelheiten der vorliegenden Erfindung ergeben sich aus der nachfolgenden Beschreibung einer bevorzugten Ausführungsform anhand der Figuren. Dabei zeigen

Figur 1 und 2     eine Plattform mit drei einphasigen Motoren,

Figur 3 und 4     Schaltbilder zur Ansteuerung der Motoren.

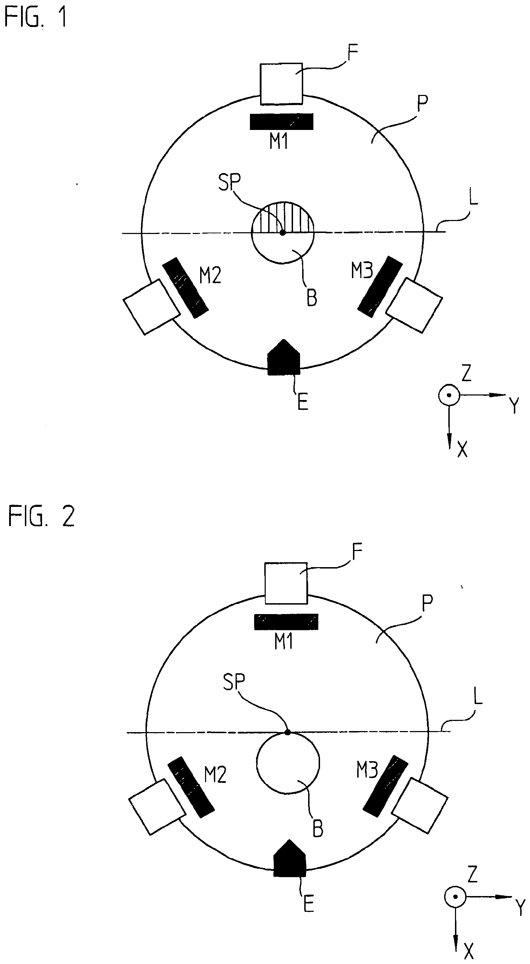

Figur 1 zeigt eine Plattform P, die mittels dreier Blattfedern F in einer Z-Richtung beweglich gelagert ist. Die Z-Richtung steht dabei senkrecht auf der Plattform P und wird hier auch als Normalenrichtung Z bezeichnet. Bewegungen in anderen linearen und rotatorischen Freiheitsgraden sind durch die Blattfedern F blockiert.

Die Plattform P ist durch drei Motoren M1, M2, M3 in der Normalenrichtung Z verstellbar. Bei den Motoren M1, M2, M3 handelt es sich um einphasige Motoren, die gleichmäßig am Umfang der Plattform P verteilt sind. Es eignen sich beispielsweise Voice-Coil-Motoren, die jeweils aus einer Spule in einem permanenten Magnetfeld aufgebaut sind. Magnetfeld und Spulenachse liegen parallel zur Z-Richtung, so dass eine zur Stromstärke proportionale Kraft in diese Richtung erzeugt wird, wenn die Spule von einem Strom durchflossen wird. Die Richtung des Stromes in der Spule entscheidet dabei, ob die Kraft in positive oder negative Z - Richtung wirkt.

Sind die Motoren M1, M2, M3 der Figur 1 identisch, insbesondere was ihre Motorkonstante, also die pro Stromeinheit erzeugte Kraft angeht, und fließt durch alle Motoren M1, M2, M3 der gleiche Strom, so greift die insgesamt auf die Plattform P wirkende Kraft etwa in der Mitte der Plattform an. Dann sollte sich die Plattform als ganzes in die gewünschte Richtung bewegen, ohne zu verkippen. Es genügt dann, mit einem einzigen Positionsmessgerät E die Lage der Plattform P in Z-Richtung zu überwachen, und den so ermittelten Positionswert für einen Lageregelkreis zu verwenden.

In der Praxis sind aber weder die Motoren M1, M2, M3 exakt gleichmäßig am Umfang der Plattform P verteilt, noch sind die Motorkonstanten der Motoren M1, M2, M3 völlig identisch. Dies führt dazu, dass die resultierende Kraft nicht genau mittig, sondern irgendwo in einem gewissen Bereich B angreift. Da dieser Angriffsbereich B den Schwerpunkt SP bzw. eine im Bereich des Schwerpunktes verlaufende mögliche Kippachse L der Plattform P umgibt, lässt sich nicht vorhersagen, ob die Plattform P bei einer Bewegung in Z-Richtung zusätzlich eine Kippbewegung durchführt. Dann kann es im ungünstigsten Fall sogar unmöglich sein, die Plattform P mit nur einem Positionsmessgerät E zu regeln. Denn liegt der tatsächliche Angriffspunkt der resultierenden Kraft aller Motoren M1, M2, M3 bezüglich der Kippachse L dem Positionsmessgerät E gegenüber, so führt diese Kraft zu einer Kippung bzw. Drehung der Plattform P um die Kippachse L, und damit z.B. zu einer Positionsänderung am Positionsmessgerät E, die auf eine nach unten bewegte Plattform P schließen lässt, obwohl die Motoren eine Kraft nach oben ausüben und sich der Schwerpunkt SP der Plattform P auch nach oben bewegt. In so einem Fall wäre das System nicht regelbar.

Dieser Effekt kann schon dann eintreten, wenn der tatsächliche Angriffspunkt der Kraft in einem vom Positionsmessgerät E abgewandten Teil des Bereichs B liegt, der von der Kippachse L abgetrennt wird, die auf der Verbindung zwischen Positionsmessgerät E und Schwerpunkt SP in etwa senkrecht steht und in der Nähe des Schwerpunkts SP verläuft. Dieser kritische Bereich ist in der Figur 1 schraffiert dargestellt. Bezogen auf den Encoder E darf der Angriffspunkt der Kraft aller Motoren M1, M2, M3 nicht jenseits der Kippachse L liegen.

Ein Ausweg wäre, ein Positionsmessgerät im Bereich eines jeden Motors M1, M2, M3 vorzusehen, und jeden Motor separat zu regeln. Dies würde jedoch einen erheblichen Mehraufwand bedeuten, da zusätzliche Positionsmessgeräte und Regelschleifen nötig wären.

Ein anderer Weg besteht darin, denn Bereich B so zu verschieben, dass der Bereich B vollständig auf der dem Positionsmessgerät E zugewandten Seite der Kippachse L liegt, wie es in der Figur 2 dargestellt ist. Der Bereich B liegt nun vollständig auf der dem Positionsmessgerät E zugewandten Seite der Kippachse L. Deshalb wird selbst bei einer Verkippung der Plattform P am Positionsmessgerät E eine Änderung des Lagewerts erhalten, die in die gleiche Richtung geht wie die Bewegung des Schwerpunktes SP der Plattform P. Damit bleibt das System regelbar.

Es soll im Folgenden ein Verfahren und ein Plattform P beschrieben werden, mit der die Lage des Angriffsbereichs B wie oben gefordert eingestellt werden kann, wobei der dafür nötige Aufwand klein gehalten wird.

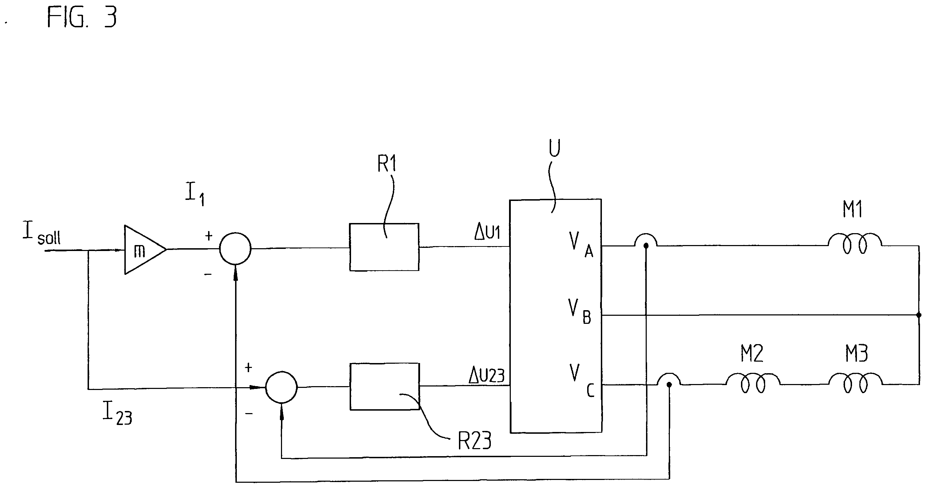

Gemäß der Figur 3 werden die drei Motoren M1, M2, M3 an einem herkömmlichen dreiphasigen Umrichter U betrieben, indem der erste Motor M1 zwischen der ersten Phase $V_A$ und der zweiten Phase $V_B$ des Umrichters U betrieben wird, und eine Reihenschaltung aus zweitem und drittem Motor M2, M3 zwischen der zweiten und dritten Phase $V_B$, $V_C$.

Teilt man nämlich die Motoren M1, M2, M3 so ein, dass die beiden in Reihe geschalteten Motoren M2, M3 im selben, von der Kippachse L abgetrennten Bereich der Plattform P liegen wie das Positionsmessgerät E, und der einzeln betriebene Motor M1 gegenüber des Positionsmessgerätes E (so wie in der Figur 3 dargestellt), so kann man dafür Sorge tragen, dass ein zunächst für alle Motoren gedachter Sollstrom Isoll so an den Umrichter U weitergegeben wird, dass die beiden Motoren M2, M3 jeweils eine etwas größere Kraft bewirken als der Motor M1. Dadurch wird die geforderte Verschiebung des Angriffsbereichs B erreicht.

Hierzu wird im Ausführungsbeispiel der Figur 3 der Sollstrom Isoll für den Regelzweig des Motors M1 mit einem parametrierbaren Faktor m nahe eins multipliziert. Für den hier gezeigten Fall muss dieser Faktor m etwas kleiner als 1 liegen. Dann ist der durch den Motor M1 fließende Strom betragsmäßig kleiner als der durch die Motoren M2, M3 fließende Strom, der Angriffspunkt der Kraft aller Motoren M1, M2, M3 verschiebt sich in Richtung des Positionsmessgerätes E, wie in der Figur 2 dargestellt.

Ordnete man die Motoren M1, M2, M3 aber so an, dass der Motor M1 im Bereich des Positionsmessgerätes E liegt, und die beiden anderen, in Reihe geschalteten Motoren M2, M3 gegenüber, so müsste der Faktor m etwas größer als 1 gewählt werden, um die gewünschte Verschiebung des Angriffsbereichs B zu erreichen.

In der Figur 3 erkennt man zwei Stromregelkreise: Einen für den leicht modifizierten Sollstrom I1 = m * Isoll für den Motor M1, und einen für den Sollstrom I23 = Isoll, der durch die beiden Motoren M2 und M3 fließen soll. Beide Regelkreise enthalten einen PI - Regler R1, R23, der aus der Differenz des jeweiligen Sollstromes I1, I23 und den jeweils gemessenen tatsächlichen Strömen die Sollspannungsdifferenz ΔU1, ΔU23 erregelt, die an den Umrichter U abgegeben wird.

Das in der Figur 3 dargestellte Ausführungsbeispiel hat den Nachteil, dass durch den Faktor m auch die Kraft beeinflusst wird, die insgesamt auf die Plattform P ausgeübt wird, da sich auch der Strom ändert, der insgesamt durch die Motoren M1, M2, M3 fließt.

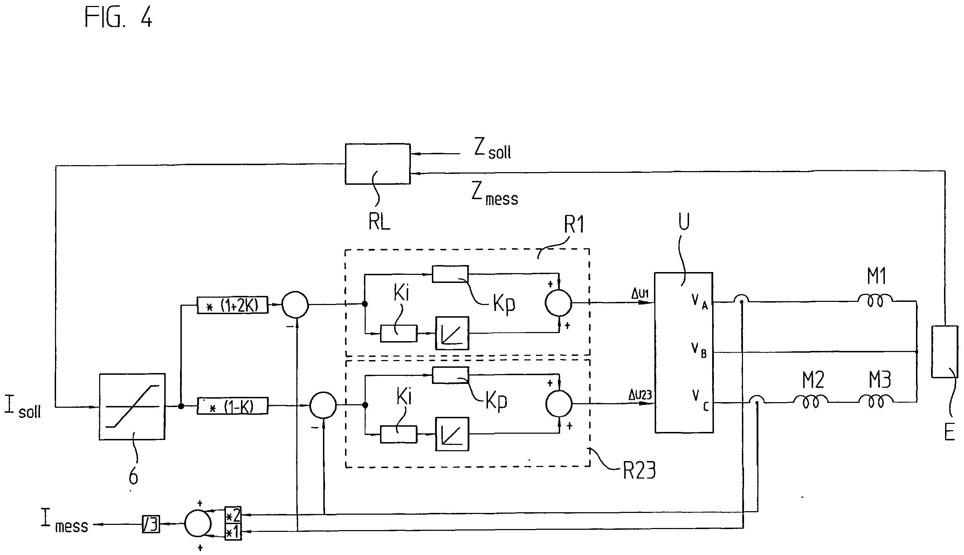

In der Figur 4 ist ein demgegenüber bevorzugtes Ausführungsbeispiel gezeigt, das diesen Nachteil nicht aufweist. Hier wird eine an die spezielle Konfiguration der Motoren M1, M2, M3 angepasste Parametrierung zur Berechnung der Sollströme I1 bzw. I23 verwendet, die sicherstellt, dass die von den Motoren M1, M2, M3 insgesamt aufgebrachte Kraft stets der Kraft entspricht, die durch den für alle Motoren vorgegebenen Sollstrom Isoll gegeben ist.

In der Figur 4 ist ein Schaltbild für eine Ansteuerung der Motoren M1, M2, M3 gezeigt, die in der gleichen Weise an einen Umrichter U angeschlossen sind wie im ersten Ausführungsbeispiel. Ein einzelner Stromsollwert Isoll wird vorgegeben. In Verbindung mit der näherungsweise für alle drei Motoren M1, M2, M3 gleichen Motorkonstante bewirkt dieser Strom eine Kraft, die in etwa mittig an der Plattform P angreift, und die dreifach größer ist als die Kraft eines einzelnen Motors. Der genaue Angriffspunkt ist jedoch wegen der Streuung der Motoreigenschaften und der nie ganz exakten Montage der Motoren nicht bekannt, der Angriffspunkt liegt deshalb irgendwo innerhalb des Angriffsbereichs B.

Um nun die einzelnen Kräfte so beeinflussen zu können, dass einerseits die gesamte Kraft gleich bleibt, und andererseits der Angriffsbereich B so liegt, dass die Lage der Plattform P in Z-Richtung regelbar ist, wird für jeden der beiden Zweige ein eigener Sollstrom I1 bzw. I23 gebildet. Es gilt:

$$I1 = Isoll * (1 + 2 * K)$$

und

$$I23 = Isoll * (1 – K)$$

mit einem Parameter K aus dem Intervall [-1;1] oder bevorzugt [-0,5; 0,5]. Dies bedeutet, dass der Sollstrom I1 für den ersten Motor M1 betragsmäßig um den Faktor 2 weiter vom Stromsollwert Isoll entfernt liegt als der Sollstrom I23 für den zweiten und dritten Motor. Da der Sollstrom I23 jedoch durch zwei Motoren fließt, der Sollstrom I1 jedoch nur durch einen Motor, ist die insgesamt von allen drei Motoren M1, M2, M3 aufgebrachte Kraft unabhängig vom Parameter K.

Durch geeignete Wahl des Parameters K kann damit der Angriffsbereich B der Kraft verschoben werden, bis sicher gestellt ist, dass er vollständig auf der dem Positionsmessgerät E zugewandten Seite der Kippachse L der Plattform P liegt.

Vorteilhaft wird auch ein Begrenzer G für den Stromsollwert Isoll an den Parameter K angepasst. Existiert nämlich ein Grenzwert für den Stromsollwert Isoll, der dem für einen der Motoren M1, M2, M3 maximal zulässigen Strom Imax entspricht, so sollte berücksichtigt werden, dass der Sollstrom Isoll unterschiedlich auf die Motoren M1, M2, M3 verteilt wird. Liegt der Grenzwert für einen Motor bei Imax, so muss der Begrenzer G den Stromsollwert bereits bei einem reduzierten Grenzwert Ig begrenzen. Es gilt

$$Ig = Imax / max ((1 + 2 * K), (1 - K))$$

oder auch

$$Ig = Imax / max ((I1/Isoll), (I23/Isoll))$$

Die Funktion max() liefert hierbei den größten der übergebenen Werte zurück. So beträgt der größte in einem der Motoren M1, M2, M3 fließende Strom gerade Imax, und die Begrenzung wirkt auf alle Motoren gleich, so dass sich im Falle einer Begrenzung des Sollstromes Isoll der Angriffspunkt der Kraft an der Plattform P bzw. der Angriffsbereich B nicht verändert.

Die Sollströme werden wiederum herkömmlichen PI-Reglern R1, R23 zugeführt. Um von allen Motoren M1, M2, M3 das gleiche dynamische Verhalten zu bekommen, sollten die Verstärkungsfaktoren Ki und Kp des Reglers R23 der Motoren M2, M3 in etwa doppelt so groß sein wie die entsprechenden Verstärkungsfaktoren des Reglers R1.

Die beiden Regler R1, R23 erregeln Sollspannungsdifferenzen ΔU1 bzw. ΔU23, die an den Umrichter U übergeben werden. Die Ausgangsspannungen der drei Phasen $V_A$, $V_B$, $V_C$ des Umrichters U müssen dann wie folgt eingestellt werden:

$$V_A = \Delta U1 - 0,5 * \Delta U23$$

$$V_B = -0,5 * \Delta U23$$

$$V_C = +0,5 * \Delta U23$$

Zu allen drei Ausgangsspannungen muss noch die mittlere Busspannung des Umrichters addiert werden, falls diese nicht 0 ist.

Die Ausgangsspannungen der drei Phasen $V_A$, $V_B$, $V_C$ können dabei mittels eines PWM - Verfahrens eingestellt werden, aber auch andere Methoden zum Einstellen einer vorgegebenen Spannung können eingesetzt werden, z.B. lineare Verstärker.

Um dem Anwender der Plattform eine möglichst einfache und klar verständliche Rückmeldung über den in den Motoren M1, M2, M3 fließenden Strom zu geben, wird der in den beiden Motorstromkreisen für Regelungszwecke gemessene Strom aufaddiert, wobei der Strom des ersten Motors einfach, der Strom durch die beiden in Reihe geschalteten Motoren M2, M3 jedoch zweifach gewichtet wird. Die so gebildete Summe wird dann durch drei geteilt und dem Anwender als Messung des in den Motoren M1, M2, M3 fließenden Stromes Imess angezeigt.

In der Figur 4 ist der Vollständigkeit halber schematisch auch der Encoder E dargestellt, mit dem eine aktuelle Position Zmess der Plattform P abgegriffen wird. Diese aktuelle Position Zmess wird zusammen mit einer Sollposition Zsoll einem Lageregler RL zugeführt, der daraus den Stromsollwert Isoll erregelt.

Der Parameter K kann bestimmt werden, indem man zunächst die maximal mögliche Streuung der bestimmenden Faktoren wie Motorkonstanten und Anordnung der Motoren M1, M2, M3 ermittelt, und dann den Parameter K so wählt, dass auch unter ungünstigsten Bedingungen die Regelbarkeit der Anordnung gewährleistet ist. Alternativ kann das Regelverhalten der Anordnung untersucht werden, und beispielsweise anhand von Bode-Diagramen nach einer passenden Einstellung für den Parameter K gesucht werden.

Die beiden Motoren M2 und M3 sind in den beiden vorausgegangen Ausführungsbeispielen in Serie geschaltet. Es ist jedoch auch möglich, die beiden Motoren M2, M3 parallel zwischen die zweite und dritte Phase des Umrichters zu schalten. Da die Motoren gleichartig sind, fließt auch so der gleiche Strom in beiden Motoren.

Wandelt man das zweite Ausführungsbeispiel gemäß Figur 4 ab, indem man die beiden Motoren M2, M3 parallel statt seriell zwischen die zweite und dritte Phase $V_B$, $V_C$ des Umrichters U schaltet, so ergeben sich Änderungen in den zum zweiten Ausführungsbeispiel angegebenen Formeln. Für dieses dritte, wegen der lediglich geringfügigen Abwandlung der Figur 4 nicht separat gezeichnete Ausführungsbeispiel, gilt zunächst eine andere Aufteilung des Stromsollwerts Isoll:

$$I1 = Isoll * (1 + K)$$

und

$$I23 = Isoll * (2 - K)$$

Die Verstärkungsfaktoren Ki, Kp des Reglers R23 der Motoren M2, M3 sollten hier in etwa gleich groß sein wie die entsprechenden Verstärkungsfaktoren Ki, Kp des Reglers R1 des ersten Motors M1.

Für den Begrenzer G und dessen Grenzwert Ig gilt hier:

$$Ig = Imax / max ((1 + K), (2 - K)/2)$$

In jedem der beiden Motoren M2, M3 fließt nämlich nun gerade der halbe Sollstrom I23.

Die beiden Regler R1, R23 erregeln auch hier Sollspannungsdifferenzen $\Delta U1$ bzw. $\Delta U23$, die an den Umrichter U übergeben werden. Die Ausgangsspannungen der drei Phasen $V_A$, $V_B$, $V_C$ des Umrichters U müssen dann wie folgt eingestellt werden:

$$V_B = -0,5 * \Delta U23,$$

falls abs($\Delta U23$) > abs($\Delta U1$), bzw.

$$V_B = -0,5 * \Delta U1$$

sonst, und

$$V_A = V_B + \Delta U1$$

$$V_C = V_B + \Delta U23$$

Die Funktion abs() liefert hierbei den absoluten Betrag des übergebenen Wertes zurück.

In den gezeigten Ausführungsbeispielen bestand jeder Motor aus einer einzigen Spule. Alternativ kann ein Motor aber auch mehrere Spulen parallel oder in Reihe geschaltet aufweisen.

## Patentansprüche

1. Verfahren zum Ansteuern von genau drei einphasigen Motoren (M1, M2, M3) und Bewegen einer Plattform (P) in eine Normalenrichtung (Z) senkrecht zur Plattform (P), **dadurch gekennzeichnet, dass** die genau drei Motoren (M1, M2, M3) von einem dreiphasigen Umrichter (U) angesteuert werden, wobei ein erster Motor (M1) zwischen einer ersten Phase ($V_A$) und einer zweiten Phase ($V_B$) des Umrichters (U) betrieben wird, und eine Reihen- oder Parallelschaltung aus einem zweiten und dritten Motor (M2, M3) zwischen einer zweiten Phase ($V_B$) und einer dritten Phase (Vc) des Umrichters (U) betrieben wird, wobei für den ersten Motor (M1) ein erster Sollstrom (I1) gebildet wird, und für den zweiten und dritten Motor (M2, M3) ein zweiter Sollstrom (I23) gebildet wird.

2. Verfahren nach Anspruch 1, **dadurch gekennzeichnet, dass** ein für alle drei Motoren (M1, M2, M3) vorgegebener gemeinsamer Stromsollwert (Isoll) eine von den drei Motoren (M1, M2, M3) insgesamt resultierende Kraft bestimmt.

3. Verfahren nach Anspruch 2, **dadurch gekennzeichnet, dass** der gemeinsame Stromsollwert (Isoll) so in den ersten und zweiten Sollstrom (I1, I23) umgerechnet wird, dass sich ein Angriffsbereich (B) der resultierenden Kraft der drei Motoren (M1, M2, M3) in Richtung eines Positionsmessgerätes (E) verschiebt, mit dem die Lage der Plattform (P) in der Normalenrichtung (Z) überwacht wird.

4. Verfahren nach einem der Ansprüche 1 - 3, **dadurch gekennzeichnet, dass** aus dem ersten und zweiten Sollstrom (I1, I23) mittels jeweils eines ersten und zweiten Stromreglers (R1, R23) erste und zweite Sollspannungen ($\Delta U1$, $\Delta U23$) gebildet werden, die an den ersten Motor (M1) bzw. an die Reihen- oder Parallelschaltung aus zweitem und drittem Motor (M2, M3) anzulegen sind, um den jeweiligen Sollstrom (I1, I23) zu erhalten.

**5.** Verfahren nach Anspruch 4, **dadurch gekennzeichnet, dass** die Sollspannungen ($\Delta U1$, $\Delta U23$) zur Ansteuerung des dreiphasigen Umrichters (U) verwendet werden, so dass zwischen der ersten Phase (VA) und zweiten Phase ($V_B$) die Sollspannung ($\Delta U1$) für den ersten Motor (M1) liegt, und zwischen der dritten Phase (VC) und der zweiten Phase (VB) die Sollspannung ($\Delta U23$) für die Reihenschaltung aus zweitem und dritten Motor (M2, M3) liegt.

**6.** Plattform, die durch genau drei einphasige Motoren (M1, M2, M3) in einer Normalenrichtung (Z) senkrecht zur Plattform (P) verstellbar ist, **dadurch gekennzeichnet, dass** die genau drei Motoren (M1, M2, M3) an einen dreiphasigen Umrichter (U) angeschlossen sind, indem ein erster Motor (M1) zwischen einer ersten Phase ($V_A$) und einer zweiten Phase ($V_B$) des Umrichters (U) angeschlossen ist, und ein zweiter und dritter Motor (M2, M3) in Reihe oder parallel geschaltet zwischen der zweiten Phase ($V_B$) und der dritten Phase ($V_B$) angeschlossen sind, wobei für den ersten Motor (M1) ein erster Sollstrom (I1) gebildet ist, und für den zweiten und dritten Motor (M2, M3) ein zweiter Sollstrom (I23) gebildet ist.

**7.** Plattform nach Anspruch 6, **dadurch gekennzeichnet, dass** die Lage der Plattform (P) in der Normalenrichtung (Z) von einem einzigen Positionsmessgerät (E) erfasst wird.

**Claims**

**1.** Method for controlling precisely three single-phase motors (M1, M2, M3) and moving a platform (P) in a normal direction (Z) perpendicular to the platform (P), **characterized in that** the precisely three motors (M1, M2, M3) are controlled by a three-phase inverter (U), wherein a first motor (M1) is operated between a first phase ($V_A$) and a second phase ($V_B$) of the inverter (U) and a series circuit or parallel circuit of a second and third motor (M2, M3) is operated between a second phase ($V_B$) and a third phase ($V_C$) of the inverter (U), wherein a first desired current (I1) is formed for the first motor (M1) and a second desired current (123) is formed for the second and third motor (M2, M3).

**2.** Method according to Claim 1, **characterized in that** a common current desired value (Isoll) that is predetermined for all three motors (M1, M2, M3) determines a force that results from the three motors (M1, M2, M3) altogether.

**3.** Method according to Claim 2, **characterized in that** the common current desired value (Isoll) is thus converted into the first and second desired current (I1, I23) in such a manner that a region of engagement (B) of the resulting force of the three motors (M1, M2, M3) displaces in the direction of a position measuring device (E) with which the position of the platform (P) is monitored in the normal direction (Z).

**4.** Method according to any one of claims 1 to 3, **characterized in that** first and second desired voltages ($\Delta U1$, $\Delta U23$) are formed from the first and second desired current (I1, I23) by means of respectively a first and second current controller (R1, R23) and said desired voltages are to be applied to the first motor (M1) or to the series circuit or parallel circuit of the second and third motor (M2, M3) in order to obtain the respective desired current (I1, I23).

**5.** Method according to Claim 4, **characterized in that** the desired voltages ($\Delta U1$, $\Delta U23$) are used so as to control the three-phase inverter (U) with the result that the desired voltage ($\Delta U1$) for the first motor (M1) lies between the first phase ($V_A$) and second phase (VB) and the desired voltage ($\Delta U23$) for the series circuit of the second and third motor (M2, M3) lies between the third phase (VC) and the second phase (VB).

**6.** Platform that may be adjusted by means of precisely three single-phase motors (M1, M2, M3) in a normal direction (Z) perpendicular to the platform (P), **characterized in that** the precisely three motors (M1, M2, M3) are connected to a three-phase inverter (U) **in that** a first motor (M1) is connected between a first phase ($V_A$) and a second phase ($V_B$) of the inverter (U), and a second and third motor (M2, M3) are connected in series or parallel between the second phase ($V_B$) and the third phase ($V_B$), wherein a first desired current (I1) is formed for the first motor (M1) and a second desired current (I23) is formed for the second and third motor (M2, M3).

**7.** Platform according to Claim 6, **characterized in that** the position of the platform (P) is detected in the normal direction (Z) by a single position measuring device (E).

**Revendications**

**1.** Procédé pour commander exactement trois moteurs (M1, M2, M3) monophasés et déplacer une plate-forme (P) dans une direction normale (Z) perpendiculaire à la plate-forme (P), **caractérisé en ce que** les exactement trois moteurs (M1, M2, M3) sont commandés par un convertisseur statique (U) triphasé, un premier moteur (M1) fonctionnant entre une première phase ($V_A$) et une deuxième phase ($V_B$) du convertisseur statique (U) et un circuit série ou parallèle composé d'un deuxième et d'un troisième moteur (M2, M3) fonctionnant entre une deuxième phase (V$_B$) et une troisième phase (Vc) du convertisseur statique (U), un premier courant de consigne (I1) étant formé pour le premier moteur (M1) et un deuxième courant de consigne (I23) étant formé pour les deuxième et troisième moteurs (M2, M3).

2. Procédé selon la revendication 1, **caractérisé en ce qu'**une valeur de consigne de courant (Isoll) commune prédéfinie pour les trois moteurs (M1, M2, M3) détermine une force résultante au total des trois moteurs (M1, M2, M3) .

3. Procédé selon la revendication 2, **caractérisé en ce que** la valeur de consigne de courant (Isoll) est convertie en le premier et le deuxième courant de consigne (I1, I23), de sorte qu'une plage d'attaque (B) de la force résultante des trois moteurs (M1, M2, M3) se décale en direction d'un appareil de mesure de position (E) avec lequel est surveillée la position de la plate-forme (P) dans la direction normale (Z).

4. Procédé selon l'une des revendications 1 à 3, **caractérisé en ce que** des première et deuxième tensions de consigne (∆U1, ∆U23) sont formées à partir du premier et du deuxième courant de consigne (I1, I23) respectivement au moyen d'un premier et d'un deuxième régulateur de courant (R1, R23), lesquelles sont à appliquer au premier moteur (M1) ou au circuit série ou parallèle composé du deuxième et du troisième moteur (M2, M3) en vue d'obtenir le courant de consigne (I1, I23) respectif.

5. Procédé selon la revendication 4, **caractérisé en ce que** les tensions de consigne (∆U1, ∆U23) sont utilisées pour la commande du convertisseur statique (U) triphasé de sorte que la tension de consigne (∆U1) pour le premier moteur (M1) est présente entre la première phase (V$_A$) et la deuxième phase (V$_B$), et la tension de consigne (∆U23) pour le circuit série composé du deuxième et du troisième moteur (M2, M3) est présente entre la troisième phase (V$_C$) et la deuxième phase (V$_B$).

6. Plate-forme qui peut être positionnée par exactement trois moteurs (M1, M2, M3) monophasés dans une direction normale (Z) perpendiculaire à la plate-forme (P), **caractérisée en ce que** les exactement trois moteurs (M1, M2, M3) sont raccordés à un convertisseur statique (U) triphasé, **en ce qu'**un premier moteur (M1) est raccordé entre une première phase (V$_A$) et une deuxième phase (V$_B$) du convertisseur statique (U) et un deuxième et un troisième moteur (M2, M3) sont branchés en série ou en parallèle entre la deuxième phase (V$_B$) et une troisième phase (V$_B$), un premier courant de consigne (I1) étant formé pour le premier moteur (M1) et un deuxième courant de consigne (I23) étant formé pour les deuxième et troisième moteurs (M2, M3).

7. Plate-forme selon la revendication 6, **caractérisée en ce que** la position de la plate-forme (P) dans la direction normale (Z) est détectée par un appareil de mesure de position (E).

FIG. 1

FIG. 2

EP 2 395 653 B1

FIG. 3

FIG. 4

EP 2 395 653 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6841956 B2
- DE 19956709 A1
- FR 2924874 A1
- DE 102008042201 A1
- EP 1691476 B1